Europäisches Patentamt

European Patent Office

Office européen des brevets

(19)

(11) **EP 1 502 969 A1**

(12) **DEMANDE DE BREVET EUROPEEN**

(43) Date de publication:
**02.02.2005 Bulletin 2005/05**

(51) Int Cl.$^7$: **C23C 16/507**, C23C 16/34, C23C 16/40

(21) Numéro de dépôt: **04291780.7**

(22) Date de dépôt: **12.07.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **31.07.2003 FR 0309422**

(71) Demandeur: **ALCATEL**
**75008 Paris (FR)**

(72) Inventeurs:
• **Jany, Christophe**
**77300 Fontainebleau (FR)**

• **Puech, Michel**
**74370 Metz-Tessy (FR)**

(74) Mandataire: **Lamoureux, Bernard et al**
**COMPAGNIE FINANCIERE ALCATEL**
**Département Propriété Industrielle**
**54, rue La Boétie**
**75008 Paris (FR)**

Remarques:
La demande, qui etait incomplète (revendications 10 et 11 manquantes) au moment du dêpot, est publiée telle quelle (article 93 (2) CBE).

(54) **Procédé et dispositif pour le dépôt peu agressif de films diélectriques en phase vapeur assisté par plasma**

(57) Selon l'invention, pendant un dépôt chimique en phase vapeur assisté par plasma (PECVD) sur un substrat (15), par exposition, sous vide, du substrat (15) à un flux de particules générées par un plasma et qui réagissent pour former une couche de passivation sur le substrat (15), on interpose, entre le plasma et le substrat (15), une grille (17) qui réduit le flux de particules chargées vers le substrat (15) tout en conservant un flux de particules neutres. La grille (17) est formée de fils métalliques entrecroisés selon un pas inférieur à deux ou trois fois la longueur de Debye ($\lambda D$) du plasma utilisé au moins en début de dépôt. On améliore ainsi les propriétés de vieillissement des composants semi-conducteurs réalisés par un tel procédé.

FIG. 2

EP 1 502 969 A1

**Description**

La présente invention concerne les procédés de fabrication de composants semi-conducteurs dans lesquels on réalise au moins une étape de dépôt chimique en phase vapeur assisté par plasma, consistant à exposer, sous vide, un substrat semi-conducteur à un flux de particules générées par un plasma, les particules réagissant pour former sur le substrat une couche de passivation en un matériau ayant des propriétés diélectriques.

Les procédés traditionnels de dépôt chimique en phase vapeur, qui sont couramment utilisés pour réaliser des dépôts de films sur des substrats, conduisent à chauffer le substrat à des températures élevées. Ces procédés ne sont utilisables que pour des substrats supportant les températures élevées sans dégradation sensible.

Pour réaliser des dépôts sur des substrats relativement fragiles, on utilise couramment le dépôt chimique en phase vapeur assisté par plasma (PECVD), procédé au cours duquel on expose, sous vide, un substrat à un flux de particules générées par un plasma et qui réagissent pour former une couche de passivation sur le substrat. Un tel dépôt peut être réalisé à température plus faible, de l'ordre de 250°C à 400°C. Mais la plupart des sources de plasma conduisent à réaliser le procédé à température encore trop élevée pour certains substrats semi-conducteurs fragiles, et les composants semi-conducteurs ainsi réalisés présentent des défauts de vieillissement progressifs qui les rendent rapidement impropres à l'utilisation.

On a encore imaginé d'utiliser une source de plasma à couplage inductif, encore appelé ICP, consistant à générer le plasma par excitation électromagnétique au moyen d'une antenne en boucle placée à l'extérieur du compartiment de génération de plasma, dont la paroi est réalisée en matériau diélectrique. Une telle source ICP permet un fonctionnement à plus faible température, sans chauffage volontaire du substrat. Le substrat se trouve alors à une température de l'ordre de 50°C en cours de dépôt. On constate qu'on améliore ainsi le vieillissement des composants semi-conducteurs.

Un vieillissement rapide et inacceptable est encore constaté sur des éléments à substrat semi-conducteur fragile, tel que le phosphure d'indium InP, l'arséniure de gallium GaAS, et même des substrats en silicium ou en germanium.

Il existe encore un besoin pour améliorer les propriétés dans le temps des composants semi-conducteurs, afin qu'ils conservent leurs propriétés après une période longue de vie.

Par exemple, dans les diodes PIN, permettant de détecter la lumière, le substrat est en phosphure d'indium. Au fil du temps, les diodes PIN réalisées par les procédés actuels perdent leur caractère isolant en l'absence de lumière. Il en résulte un courant de fuite indésirable qui fait perdre la capacité globale de détection de la diode et sa sensibilité.

Pour améliorer les propriétés de vieillissement de la diode, on cherche à passiver le substrat par un dépôt de nitrure de silicium à l'aide d'un procédé (PECVD), le dépôt évitant notamment l'action de l'humidité.

Mais le dépôt n'a pas une efficacité suffisante dans le temps, et la diode perd progressivement son caractère isolant en l'absence de lumière.

La présente invention résulte de l'observation selon laquelle les défauts progressifs de vieillissement de certains composants semi-conducteurs tels que les diodes PIN sont vraisemblablement dus à une dégradation de l'interface entre le substrat et la couche de dépôt lors du dépôt de couches de passivation. En effet, au début de l'étape de dépôt, le substrat est à nu et peut se trouver lui-même dégradé par l'action du plasma.

L'hypothèse est que cette dégradation est produite par l'action des particules chargées présentes dans le plasma, qui bombardent le substrat et dégradent sa couche superficielle.

Si l'on réduit la polarisation négative du substrat, par exemple en le mettant au potentiel flottant, cela ne suffit pas à éviter l'action des particules chargées sur le substrat.

Le problème proposé par la présente invention est d'améliorer encore les propriétés de vieillissement des composants à semi-conducteur réalisés par au moins une étape utilisant un procédé de dépôt chimique en phase vapeur assisté par plasma, de façon à conserver dans le temps les propriétés du composant semi-conducteur ainsi réalisé.

Les avantages tirés d'une réduction de la température de traitement étant épuisés, l'invention vise à trouver un moyen supplémentaire pour réduire le caractère agressif du plasma vis-à-vis du substrat lors des étapes de dépôt d'un film diélectrique sur un substrat.

L'invention vise simultanément à protéger le substrat sans pour autant réduire de façon sensible la vitesse de réalisation du dépôt sur le substrat.

Pour atteindre ces buts ainsi que d'autres, un premier aspect de l'invention est de prévoir un procédé particulier pour le dépôt de films diélectriques par dépôt chimique en phase vapeur assisté par plasma (PECVD), dans lequel on expose, sous vide, un substrat à un flux de particules générées par un plasma et qui réagissent pour former une couche de passivation sur le substrat. On interpose entre le plasma et le substrat un piège sélectif qui réduit le flux de particules chargées vers le substrat tout en conservant un flux de particules neutres.

On comprend que le piège sélectif, en réduisant le flux de particules chargées, évite la dégradation de la couche superficielle de substrat au moins en début de réalisation du dépôt. Simultanément, en conservant un flux de particules neutres, le piège sélectif évite de réduire sensiblement la vitesse de dépôt.

Selon l'invention, le procédé de dépôt comprend deux étapes successives :

> a) une étape initiale de dépôt doux, au cours de laquelle le piège sélectif réduit efficacement le flux de particules chargées,
> b) une étape suivante de dépôt rapide, au cours de laquelle l'effet du piège sélectif est au moins en grande partie inhibé.

On constate en effet que la dégradation de la couche superficielle de substrat se produit essentiellement au début du dépôt, période au cours de laquelle le substrat n'est pas protégé par la couche de dépôt contre les agressions des particules de plasma. Ainsi, au cours de l'étape initiale de dépôt, on effectue un dépôt doux qui évite la dégradation de la couche superficielle de plasma. Ensuite, lorsqu'une certaine quantité de dépôt a été réalisée, on procède à une étape de dépôt rapide en inhibant l'effet retardateur du piège sélectif, de sorte que la vitesse de réalisation du dépôt est encore augmentée.

En pratique, on peut inhiber l'effet du piège sélectif notamment par l'une ou l'autre de deux opérations : une première opération consiste à modifier le piège, par exemple en le déplaçant. Une seconde opération consiste à modifier les propriétés du plasma, en faisant en sorte que les particules chargées présentes dans le plasma soient piégées lors de la première étape de dépôt doux, et que ces particules traversent le piège sans le voir lors d'une seconde étape du dépôt rapide.

Selon un second aspect, l'invention propose un dispositif pour les dépôts de films diélectriques par un procédé de dépôt chimique en phase vapeur assisté par plasma sur un substrat, tel que défini ci-dessus, le dispositif comprenant :

- une source de plasma à forte densité ionique,
- des moyens pour projeter les particules de plasma sur le substrat,
- un piège sélectif pour supprimer ou réduire sensiblement le flux de particules chargées vers le substrat tout en conservant un flux de particules neutres qui réagissent pour former une couche de passivation sur le substrat,
- des moyens pour escamoter sélectivement le piège, de telle sorte que le piège soit interposé dans le flux de particules pendant une étape initiale de dépôt doux, et que le piège soit escamoté hors du flux de particules pendant une étape suivante de dépôt rapide.

En pratique, le piège sélectif peut avantageusement comprendre une grille métallique interposée entre le plasma et le substrat.

Pour avoir un effet de piège sélectif, la grille métallique peut par exemple être formée d'un entrecroisement de fils métalliques selon un pas P déterminé en fonction des caractéristiques du plasma, de façon à bloquer le flux de particules chargées au moins pendant l'étape initiale de dépôt doux.

En pratique, il faut que le pas P de la grille soit inférieur à deux à trois fois la longueur de Debye $\lambda D$ du plasma utilisé au moins en début de dépôt.

En alternative, l'invention propose un dispositif pour les dépôts de films diélectriques par un procédé de dépôt chimique en phase vapeur assisté par plasma sur un substrat, tel que défini ci-dessus, le dispositif comprenant :

- une source de plasma à forte densité ionique,
- des moyens pour projeter les particules de plasma sur le substrat,
- un piège sélectif pour supprimer ou réduire sensiblement le flux de particules chargées vers le substrat tout en conservant un flux de particules neutres qui réagissent pour former une couche de passivation sur le substrat, le piège sélectif comprenant une grille métallique, interposée entre le plasma et le substrat, formée d'un entrecroisement de fils métalliques selon un pas P déterminé en fonction des caractéristiques du plasma pour bloquer le flux de particules chargées.

Selon l'invention, le dispositif comprend des moyens d'adaptation pour modifier la longueur de Debye des particules du plasma, la grille restant interposée en permanence dans le flux de particules pendant le dépôt, de sorte que les moyens d'adaptation réalise un plasma à longueur de Debye $\lambda D$ plus grande que le tiers ou la moitié du pas P de la grille pendant une étape initiale de dépôt doux, et les moyens d'adaptation réalisent un plasma à longueur de Debye $\lambda D$ nettement plus petite que le tiers ou la moitié du pas P de la grille pendant une étape suivante de dépôt rapide.

Le dispositif peut comprendre un anneau de serrage du substrat sur son support, et la grille peut avantageusement être isolée de l'anneau de serrage du substrat sur son support, et peut être polarisée à un potentiel différent du potentiel de l'anneau de serrage.

D'autres objets, caractéristiques et avantages de la présente invention ressortiront de la description suivante de modes de réalisation particuliers, faite en relation avec les figures jointes, parmi lesquelles:

- la figure 1 est une vue schématique générale d'un dispositif pour le dépôt chimique en phase vapeur assisté par plasma avec une source de plasma de type ICP ;
- la figure 2 illustre schématiquement, en vue de côté en coupe diamétrale, un support de substrat muni d'une grille selon un mode de réalisation de la présente invention ;
- la figure 3 est une vue de dessus de la grille ; et
- la figure 4 illustre la variation de la longueur de Debye en fonction de la densité ionique du substrat et en fonction de la température électronique du plasma.

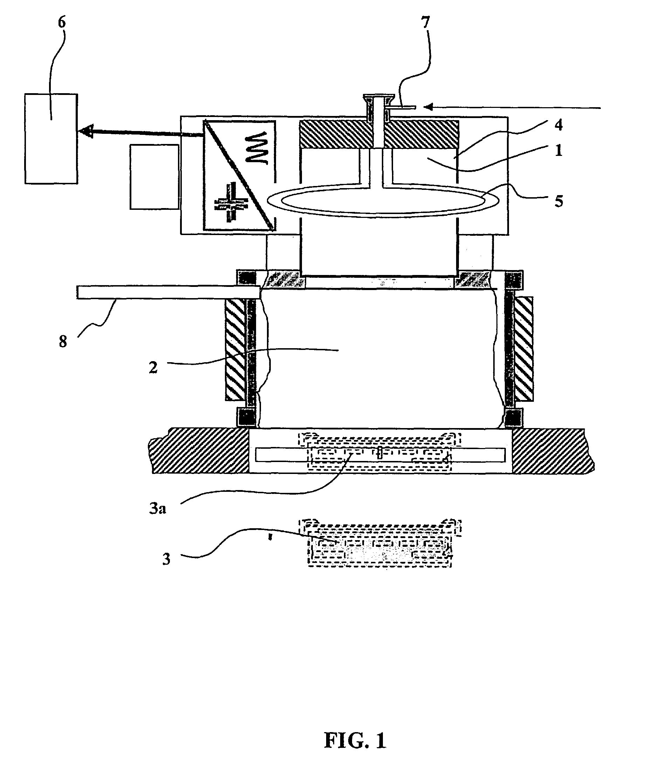

On considère tout d'abord la figure 1. Un dispositif de dépôt de film diélectrique par dépôt chimique en phase vapeur assisté par plasma (PECVD) comprend une source de plasma 1, de préférence à forte densité ionique pour fonctionner correctement à une plus basse température de fonctionnement, suivie d'une chambre de diffusion 2, avec un support de substrat 3 adapté pour tenir un substrat à traiter et pour être engagé dans la chambre de diffusion 2 comme indiqué par la position 3a.

La source de plasma 1 est constituée d'une enceinte dont la paroi 4 est en un matériau diélectrique, avantageusement de forme cylindrique, associée à une antenne 5 en boucle alimentée par un générateur électrique radiofréquence 6. Une entrée de gaz 7 est prévue à l'extrémité proximale de la source de plasma 1, c'est-à-dire à l'opposé de la chambre de diffusion 2.

La source de plasma 1 communique avec la chambre de diffusion 2, qui elle-même est adaptée pour diriger le plasma vers un substrat tenu sur le support de substrat dans la position 3a.

La chambre de diffusion 2 comporte en outre une entrée de gaz en post-décharge 8, permettant l'introduction d'un gaz en aval de la zone de création de plasma, alors que l'entrée de gaz 7 permet une entrée de gaz en amont de la zone de création de plasma.

Lors d'une procédure de dépôt chimique en phase vapeur assisté par plasma, on place un substrat sur le support de substrat 3 que l'on adapte en position 3a dans la chambre de diffusion. On réalise un vide approprié à l'intérieur de la source de plasma 1 et de la chambre de diffusion 2, on introduit de l'azote sous forme d'azote gazeux $N_2$ ou d'ammoniac $NH_3$ en amont par l'entrée de gaz 7, on amène du silicium dans la chambre de diffusion en post-décharge par l'entrée de gaz en post-décharge 8 sous forme de silane $SiH_4$, et on génère le plasma par l'alimentation du générateur électrique radiofréquence 6. Le plasma se propage dans la chambre de diffusion 2 jusqu'au substrat porté par le support de substrat 3. On forme ainsi sur le substrat une couche de dépôt en nitrure de silicium $Si_3N_4$.

De la même façon, en utilisant d'autres gaz appropriés on pourrait réaliser des couches de dépôt différentes.

La couche de dépôt passive le substrat. Mais on comprend que, en début de procédure, le substrat n'est protégé par aucune couche de dépôt, et se trouve ainsi soumis au bombardement des particules du plasma.

L'invention vise à réduire l'effet néfaste du bombardement des particules chargées présentes dans le plasma, par l'interposition d'un piège sélectif entre le plasma et le substrat porté par le support de substrat 3.

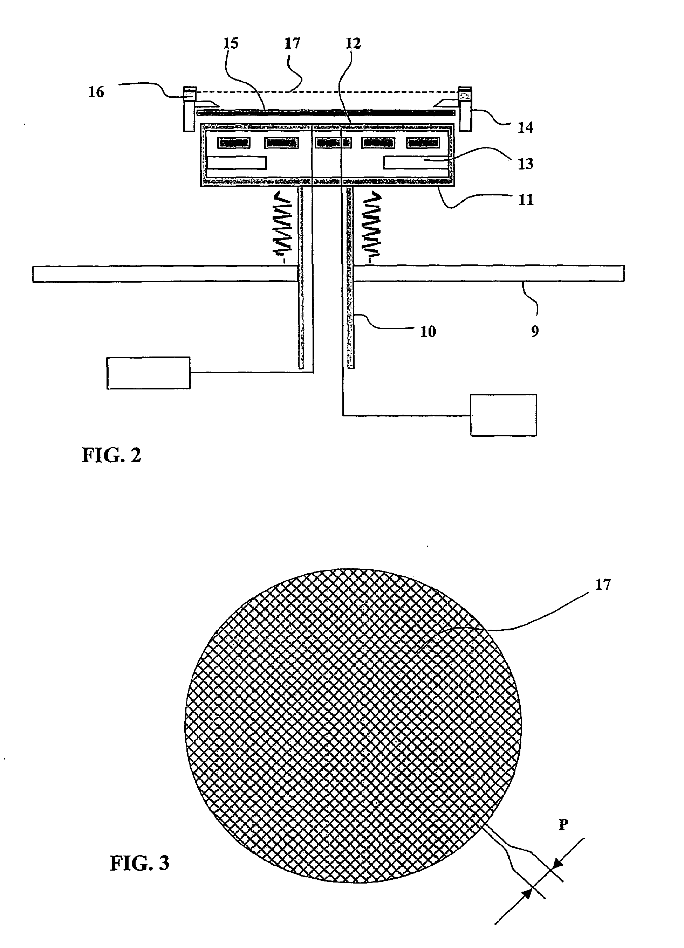

On considère maintenant les figures 2 et 3, illustrant à plus grande échelle le support de substrat 3 selon un mode de réalisation de l'invention.

On distingue de façon générale une plaque support de substrat 9, une colonne axiale de support 10 solidaire de la plaque support de substrat 9 et portant un bloc support de substrat 11 qui lui-même contient de façon connue des électrodes radiofréquence 12, des moyens chauffants 13, et qui porte un anneau de serrage 14 adapté pour maintenir un substrat 15 tel qu'une tranche de semi-conducteur.

Selon l'invention, on adapte, sur l'anneau de serrage 14, une couronne isolante 16 qui elle-même tient une grille 17 placée au-dessus du substrat 15, à distance appropriée et parallèle au substrat 15, entre le substrat 15 et le plasma.

Comme on le voit sur la figure 3 en vue de dessus, la grille 17 présente une forme circulaire, similaire à la forme de la tranche de semi-conducteur ou substrat 15, et est formée d'un entrecroisement de fils métalliques orthogonaux selon un pas P approprié.

Le pas P est déterminé en fonction des caractéristiques du plasma, de façon à bloquer le flux de particules chargées du plasma qui ne pourront ainsi pas atteindre le substrat 15, tout en laissant passer les particules neutres du plasma.

On constate un bon effet de piégeage sélectif des particules chargées du substrat lorsque le pas P de la grille 17 est inférieur à deux ou trois fois la longueur de Debye $\lambda D$ du plasma utilisé.

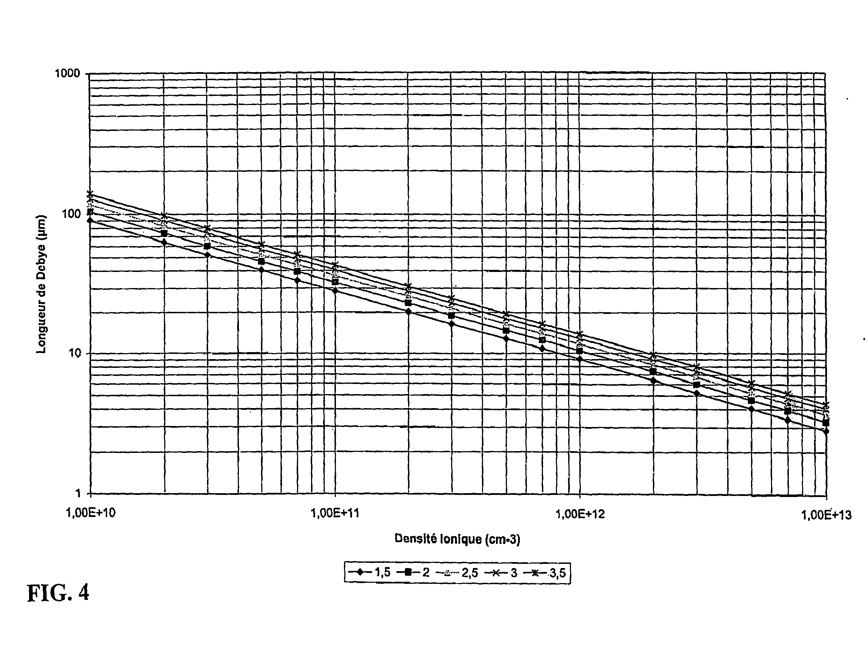

Cette longueur de Debye varie en fonction des caractéristiques du plasma, comme illustré sur la figure 4, de façon connue.

En particulier, la longueur de Debye décroît lorsque la densité ionique augmente dans le plasma, et croît lorsque la température électronique du plasma augmente. Les courbes illustrées sur la figure 4 montrent la variation de la longueur de Debye en fonction de la densité électronique pour cinq valeurs de température électronique du plasma variant progressivement de 1,5 à 3,5 eV.

On choisira donc le pas P de la grille en fonction des propriétés du plasma selon les caractéristiques indiquées sur les courbes de la figure 4.

On pourra également choisir le pas P en considérant la formule donnant la longueur de Debye :

$$\lambda D = \left(\frac{KTe}{Ne^2}\right)^{\frac{1}{2}}$$

N étant la densité ionique, Te étant la température électronique du plasma.

En pratique, on choisira un pas dont la valeur est de l'ordre de 100 microns, afin que la grille soit assez aisément réalisable.

La densité ionique peut être de l'ordre de $1{,}00E+10$ cm$^{-3}$ à $5{,}00E+10$ cm$^{-3}$.

Grâce à la présence d'une telle grille 17, seule la composante chimique du plasma traverse la grille et atteint le substrat 15, tandis que la composante électrique formée par les particules chargées électriquement se trouve piégée par la grille 17 et n'atteint pas le substrat 15.

La grille 17, isolée de l'anneau de serrage 14 par la couronne isolante 16, peut-être polarisée à un potentiel différent du potentiel de l'anneau de serrage 14.

On peut avantageusement prévoir un moyen pour escamoter sélectivement la grille 17. De la sorte, la grille 17 est interposée dans le flux de particules pendant une étape initiale de dépôt doux, évitant le passage des particules chargées, puis la grille est escamotée hors du flux de particules pendant une étape suivante de dépôt rapide, permettant l'action complète du plasma sur le substrat 15.

De façon plus avantageuse, en considérant la variation de la longueur de Debye en fonction des paramètres du plasma telle qu'illustrée sur la figure 4, on peut modifier le caractère sélectif du piège constitué par la grille 17 en modifiant les caractéristiques du plasma au cours de la procédure de dépôt.

Ainsi, le dispositif peut avantageusement comprendre des moyens d'adaptation pour modifier la longueur de Debye λD des particules de plasma, la grille 17 restant interposée en permanence dans le flux de particules pendant le dépôt. Dans ce cas, les moyens d'adaptation peuvent être des moyens pour modifier la densité ionique du plasma, ou plus avantageusement des moyens pour modifier la température électronique Te du plasma, par exemple en modifiant la puissance du générateur électrique radiofréquence 6. Ainsi, pendant une étape initiale de dépôt doux, les moyens d'adaptation réalisent un plasma à longueur de Debye λD plus grande que le tiers ou la moitié du pas P de la grille 17, alors que les mêmes moyens d'adaptation réalisent un plasma à longueur de Debye λD nettement plus petite que le tiers ou la moitié du pas P de la grille 17 pendant une étape suivante de dépôt rapide.

On comprend que, soit par déplacement de la grille, soit par modification du plasma, l'effet du piège sélectif est inhibé au cours de l'étape suivante de dépôt rapide, permettant l'effet complet du plasma pour la génération d'un dépôt sur le substrat 15.

La présente invention peut trouver des applications avantageuses notamment dans l'utilisation du dispositif tel que décrit ci-dessus pour la passivation d'un substrat semi-conducteur à base de silicium Si de germanium Ge, de phosphure d'indium InP, d'arséniure de gallium GaAS, ou d'un composé des colonnes II à VI de la classification périodique des éléments, par une couche de passivation à film de type diélectrique.

La couche de passivation peut être à base de silice $SiO_2$, ou de nitrure de silicium $Si_3N_4$, par exemple.

La présente invention n'est pas limitée aux modes de réalisation qui ont été explicitement décrits, mais elle en inclut les diverses variantes et généralisations qui sont à la portée de l'homme du métier.

**Revendications**

**1.** Procédé pour le dépôt de films diélectriques par dépôt chimique en phase vapeur assisté par plasma (PECVD), dans lequel on expose, sous vide, un substrat (15) à un flux de particules générées par un plasma qui réagissent pour former une couche de passivation sur le substrat (15), un piège sélectif (17) étant interposé entre le plasma et le substrat (15), qui réduit le flux de particules chargées vers le substrat tout en conservant un flux de particules neutres, procédé **caractérisé en ce qu'**il comprend deux étapes successives :

    a) une étape initiale de dépôt doux, au cours de laquelle le piège sélectif (17) réduit efficacement le flux de particules chargées,
    b) une étape suivante de dépôt rapide, au cours de laquelle l'effet du piège sélectif (17) est au moins en grande partie inhibé.

**2.** Procédé selon la revendication 1, dans lequel l'effet du piège sélectif est inhibé par une modification du piège, telle qu'un déplacement, au cours de l'étape de dépôt rapide.

**3.** Procédé selon la revendication 1, dans lequel l'effet du piège sélectif est inhibé par une modification des propriétés du plasma au cours de l'étape de dépôt rapide.

**4.** Dispositif pour le dépôt de films diélectriques par un procédé de dépôt chimique en phase vapeur assisté par plasma (PECVD) sur un substrat (15), comprenant

- une source de plasma (1) à forte densité ionique,
- des moyens (2) pour projeter les particules de plasma sur le substrat (15),
- un piège sélectif (17) pour supprimer ou réduire sensiblement le flux de particules chargées vers le substrat (15) tout en conservant un flux de particules neutres qui réagissent pour former une couche de passivation sur le substrat (15),

**caractérisé en ce qu'**il comprend des moyens pour escamoter sélectivement le piège (17), de telle sorte que le piège (17) soit interposé dans le flux de particules pendant une étape initiale de dépôt doux, et que le piège (17) soit escamoté hors du flux de particules pendant une étape suivante de dépôt rapide.

**5.** Dispositif selon la revendication 4, dans lequel le piège sélectif comprend une grille métallique interposée entre le plasma et le substrat.

**6.** Dispositif selon la revendication 5, dans lequel la grille métallique est formée d'un entrecroisement de fils métalliques selon un pas P déterminé en fonction des caractéristiques du plasma pour bloquer le flux de particules chargées.

**7.** Dispositif selon la revendication 6, dans lequel le pas P de la grille est inférieur à deux à trois fois la longueur de Debye λD du plasma utilisé, au moins en début de dépôt.

**8.** Dispositif pour le dépôt de films diélectriques par un procédé de dépôt chimique en phase vapeur assisté par plasma (PECVD) sur un substrat (15), comprenant

- une source de plasma (1) à forte densité ionique,
- des moyens (2) pour projeter les particules de plasma sur le substrat (15),
- un piège sélectif (17) pour supprimer ou réduire sensiblement le flux de particules chargées vers le substrat (15) tout en conservant un flux de particules neutres qui réagissent pour former une couche de passivation sur le substrat (15),

**caractérisé en ce que** le piège sélectif comprend une grille métallique (17), interposée entre le plasma et le substrat (15), formée d'un entrecroisement de fils métalliques selon un pas P déterminé en fonction des caractéristiques du plasma pour bloquer le flux de particules chargées,
et **en ce que** le dispositif comprend des moyens d'adaptation (6) pour modifier la longueur de Debye λD des particules du plasma, la grille (17) restant interposée en permanence dans le flux de particules pendant le dépôt, de sorte que les moyens d'adaptation (6) réalise un plasma à longueur de Debye (λD) plus grande que le tiers ou la moitié du pas P de la grille (17) pendant une étape initiale de dépôt doux, et les moyens d'adaptation (6) réalisent un plasma à longueur de Debye λD nettement plus petite que le tiers ou la moitié du pas P de la grille (17) pendant une étape suivante de dépôt rapide.

**9.** Dispositif selon l'une des revendications 4 à 8, comprenant un anneau de serrage (14), et dans lequel la grille est isolée de l'anneau de serrage et est polarisée à un potentiel différent du potentiel de l'anneau de serrage.

**12.** Utilisation d'un dispositif selon l'une des revendications 4 et 8 pour la passivation d'un substrat semi-conducteur à base de silicium, de germanium, de phosphure d'indium, d'arséniure de gallium, ou d'un composé II-VI par une couche de passivation à film de type diélectrique.

**FIG. 1**

FIG. 2

FIG. 3

FIG. 4

**Office européen**

**des brevets**

## RAPPORT DE RECHERCHE EUROPEENNE

Numéro de la demande

EP 04 29 1780

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | WO 00/70117 A (UNIV CALIFORNIA) 23 novembre 2000 (2000-11-23) | 1,3 | C23C16/507 C23C16/34 C23C16/40 |
| A | * page 12, ligne 13 - page 13, ligne 3; figure 1 * <br> * page 13, ligne 11-19 * <br> * page 17, ligne 1-24 * <br> * page 29, ligne 10 - page 31, ligne 16 * | 2,4-12 | |
| X | US 6 444 327 B1 (TANABE HIROSHI ET AL) 3 septembre 2002 (2002-09-03) | 1,3 | |
| A | * colonne 1, ligne 12-24 * <br> * colonne 17, ligne 14 - colonne 18, ligne 55; figure 7 * <br> * colonne 28, ligne 11 - colonne 29, ligne 53; figures 10-13 * | 2,4-12 | |
| X | US 5 304 250 A (SAMESHIMA TOSHIYUKI ET AL) 19 avril 1994 (1994-04-19) | 1,3 | |
| A | * colonne 1, ligne 7-12,22-25 * <br> * colonne 2, ligne 1-15 * <br> * colonne 3, ligne 20 - colonne 4, ligne 66; figure 1 * <br> * colonne 5, ligne 35-39 * | 2,4-12 | DOMAINES TECHNIQUES RECHERCHES (Int.Cl.7) <br><br> C23C |
| X | PATENT ABSTRACTS OF JAPAN vol. 1996, no. 10, 31 octobre 1996 (1996-10-31) -& JP 08 167596 A (SONY CORP), 25 juin 1996 (1996-06-25) | 1,3 | |
| A | * abrégé * | 2,4-12 | |
| A | US 4 987 346 A (KATZSCHNER WERNER ET AL) 22 janvier 1991 (1991-01-22) * colonne 6, ligne 7-62; figure 2 * * colonne 7, ligne 1-68 * | 4-7 | |

-/--

Le présent rapport a été établi pour toutes les revendications

| Lieu de la recherche | Date d'achèvement de la recherche | Examinateur |
|---|---|---|
| Munich | 23 août 2004 | Joffreau, P-O |

EP 1 502 969 A1

<table>
<tr><td colspan="2">⨀)) **Office européen**<br>**des brevets**</td><td>**RAPPORT DE RECHERCHE EUROPEENNE**</td><td>Numéro de la demande<br>**EP 04 29 1780**</td></tr>
</table>

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (Int.Cl.7) |
|---|---|---|---|
| A | EP 1 220 272 A (EBARA CORP)<br>3 juillet 2002 (2002-07-03)<br>* le document en entier *<br>----- | 4-7 | |
| A | TAKASHI YUNOGAMI ET AL: "DEVELOPMENT OF<br>NEUTRAL-BEAM-ASSISTED ETCHER"<br>JOURNAL OF VACUUM SCIENCE AND TECHNOLOGY:<br>PART A, AMERICAN INSTITUTE OF PHYSICS. NEW<br>YORK, US,<br>vol. 13, no. 3, PART 1,<br>1 mai 1995 (1995-05-01), pages 952-958,<br>XP000531596<br>ISSN: 0734-2101<br>* le document en entier *<br>----- | 4-7 | |

DOMAINES TECHNIQUES<br>RECHERCHES (Int.Cl.7)

Le présent rapport a été établi pour toutes les revendications

| Lieu de la recherche | Date d'achèvement de la recherche | Examinateur |
|---|---|---|
| Munich | 23 août 2004 | Joffreau, P-O |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 04 29 1780

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-08-2004

| Document brevet cité au rapport de recherche | | Date de publication | Membre(s) de la famille de brevet(s) | | Date de publication |
|---|---|---|---|---|---|
| WO 0070117 | A | 23-11-2000 | EP<br>WO<br>US | 1198610 A1<br>0070117 A1<br>2002129902 A1 | 24-04-2002<br>23-11-2000<br>19-09-2002 |
| US 6444327 | B1 | 03-09-2002 | JP<br>JP<br>US<br>US | 3164019 B2<br>10321619 A<br>2002182343 A1<br>6383299 B1 | 08-05-2001<br>04-12-1998<br>05-12-2002<br>07-05-2002 |
| US 5304250 | A | 19-04-1994 | JP | 5021393 A | 29-01-1993 |
| JP 08167596 | A | 25-06-1996 | JP | 3353514 B2 | 03-12-2002 |
| US 4987346 | A | 22-01-1991 | DE<br>AT<br>DE<br>EP<br>FI<br>JP<br>KR | 3803355 A1<br>104089 T<br>58907368 D1<br>0326824 A2<br>890497 A ,B,<br>2103932 A<br>9203019 B1 | 17-08-1989<br>15-04-1994<br>11-05-1994<br>09-08-1989<br>06-08-1989<br>17-04-1990<br>13-04-1992 |
| EP 1220272 | A | 03-07-2002 | JP<br>EP<br>WO | 2001028244 A<br>1220272 A1<br>0106534 A1 | 30-01-2001<br>03-07-2002<br>25-01-2001 |

EPO FORM P0460

Pour tout renseignement concernant cette annexe : voir Journal Officiel de l'Office européen des brevets, No.12/82